# DEMANDE DE BREVET EUROPEEN

(11) **EP 4 679 859 A1**
(43) Date de publication de la demande: **14.01.2026**
(21) Numéro de dépôt: 25182883.6
(22) Date de dépôt: 16.06.2025
(51) Int. Cl.: H04Q 9/00, G08C 25/00

(54) **PROCEDE ET SYSTEME DE COMMANDE A DISTANCE DE COMPTEURS COMMUNICANTS**

(30) Priorité: 18.06.2024 FR 2406457
(71) Demandeur: SAGEMCOM ENERGY & TELECOM SAS, 92270 Bois-Colombes (FR)
(72) Inventeur: SERGI, Jérémie, 92270 BOIS-COLOMBES (FR); DIAZ, Pierre-Stéphane, 92270 BOIS-COLOMBES (FR)
(74) Mandataire: Novagraaf Technologies

(57) **Abrégé**

Un ensemble de compteurs communicants (500) est desservi par un réseau de distribution d'énergie et en communication avec un système (400) de gestion et de collecte de données de consommation, lesdits compteurs étant configurés pour mesurer et gérer une consommation d'énergie. Le procédé comprend les étapes, mises en œuvre par une passerelle entre le système de gestion et de collecte et l'ensemble des compteurs, de :
A- recevoir des commandes pour un ou plusieurs compteurs en provenance du système de gestion et de collecte, lesdites commandes étant destinées à être exécutées par les compteurs concernés ; et
B- envoyer les commandes vers les compteurs concernés;
dans lequel l'étape B comprend la mise en œuvre d'un processus de limitation d'une quantité de commandes envoyées pendant une période de temps définie.

## Description

### Domaine technique de l'invention

La présente invention se rapporte aux systèmes de gestion et de collecte de données de consommation, tels que les systèmes AMM (de l'anglais « Advanced Metering Management »), principalement utilisés dans les systèmes et réseaux de distribution d'énergie (électricité, gaz, eau). L'invention concerne plus particulièrement un procédé de commande à distance de compteurs communicants desservis par le réseau de distribution d'énergie.

### Etat de la technique

Un système de gestion et de collecte de données de consommation, tel qu'un système AMM, a pour rôle de collecter, mesurer, analyser et gérer la consommation d'énergie (électricité, gaz, eau) de manière automatisée et en temps réel. Il utilise des compteurs intelligents, également appelés compteurs communicants, en anglais « smart meters », qui mesurent la consommation d'énergie à des intervalles de temps réguliers et gèrent la consommation d'énergie. Les compteurs intelligents sont capables de transmettre des données de consommation en énergie vers un sous-système de collecte, généralement appelé HES (de anglais « Head End System »), du système AMM, à travers un réseau de communication. Le HES joue un rôle de passerelle entre le système AMM et les compteurs. Les données de consommation provenant des compteurs et reçues par le HES sont ensuite envoyées vers un système de gestion des données de consommation, généralement appelé MDMS (de l'anglais « Meter Data Management System »), du système AMM. Le MDMS fournit une gestion complète et sécurisée des données de consommation. Le système AMM comporte également un système de gestion client, CMS (de l'anglais « Customer Management System »), en communication avec le MDMS et gérant l'interaction avec les clients.

Les compteurs intelligents peuvent recevoir des commandes à distance en provenance d'une entité du système de gestion AMM (par exemple du CMS, MDMS ou HES). Ces commandes sont destinées à être exécutées par les compteurs concernés et peuvent comprendre des commandes de lecture, des commandes de configuration, des commandes de contrôle, des commandes de maintenance, des commandes d'alerte et de notification, des commandes de sécurité, des commandes de rapport, etc. Certaines commandes, dites « critiques », sont susceptibles d'entraîner une coupure de l'alimentation. Les commandes critiques peuvent comprendre notamment :
- des ordres de coupure d'alimentation ; et
- des commandes de limitation de puissance donnant instruction aux compteurs concernés de réduire la puissance maximale disponible, ce qui peut entraîner à court terme une coupure de l'alimentation.

La mise hors service de l'alimentation en énergie au niveau d'un compteur a pour effet de générer une baisse soudaine de la consommation d'énergie au niveau d'un point livraison correspondant à un endroit spécifique où l'énergie est fournie à un utilisateur final. Si l'alimentation en énergie est mise hors service (i.e., coupée) au niveau d'un grand nombre de points de livraison pendant un court intervalle de temps, typiquement de l'ordre de quelques minutes, par le biais d'un envoi massif d'un grand nombre de commandes critiques vers les compteurs gérant ces points de livraison, cela peut provoquer un déséquilibre important et soudain entre la production et la consommation d'énergie. Un tel déséquilibre s'explique par le fait que les sources de production d'énergie ont généralement un temps de réactivité long et le réseau de distribution d'énergie ne dispose pas de capacité de stockage de l'énergie suffisante pour jouer un rôle de tampon dans ces circonstances. Cela peut engendrer un black-out, c'est-à-dire une panne totale ou quasitotale de l'alimentation en énergie dans une région, une ville ou même un pays entier.

L'envoi massif de commandes de mise hors service vers les compteurs intelligents peut être causé par une ou plusieurs erreurs humaines de gestion ou d'exploitation du réseau ou par une attaque malveillante sur un ou plusieurs composants du système AMM.

On notera qu'un risque similaire de déséquilibre existe également en cas de mise en service d'un grand nombre de points de livraison durant un court intervalle de temps, par envoi d'un grand nombre de commandes à distance de mise en service aux compteurs concernés.

La présente invention vise à améliorer la situation, notamment à limiter le risque de déséquilibre entre production et consommation d'énergie pouvant, dans certaines circonstances, entraîner un black-out du réseau de distribution d'énergie.

### Exposé de l'invention

La présente invention concerne un procédé de commande à distance d'un ensemble de compteurs communicants desservis par un réseau de distribution d'énergie et en communication avec un système de gestion et de collecte de données de consommation, lesdits compteurs étant configurés pour mesurer et gérer une consommation d'énergie, ledit procédé comprenant les étapes, mises en œuvre par une passerelle entre le système de gestion et de collecte et l'ensemble des compteurs, de: A- recevoir des commandes pour un ou plusieurs compteurs en provenance du système de gestion et de collecte, lesdites commandes étant destinées à être exécutées par les compteurs concernés ; et B- envoyer les commandes vers les compteurs concernés; dans lequel l'étape B comprend la mise en œuvre d'un processus de limitation d'une quantité de commandes envoyées pendant une période de temps définie

Le système de gestion et de collecte est par exemple un système AMM (de l'anglais « Advanced Metering Management »). La sécurité entre les sous-systèmes ou composants de l'AMM (HES, MDMS, CMS) peut présenter des failles, ce qui peut engendrer un risque significatif de perturbations, voire de black-out, au niveau du réseau de distribution d'énergie. En effet, dans un système AMM, les communications entre les composants (HES, MDMS, CMS) sont généralement protégées en termes d'intégrité et de confidentialité, par exemple par le protocole TLS. Cependant, le système AMM comporte un grand nombre d'interfaces à sécuriser entre ses sous-systèmes ainsi qu'au sein de chaque sous-système, et des composants logiciels qui peuvent être vulnérables aux risques de sécurité (ou Common Vulnerability Exposure (CVE)). En raison de la structure complexe et sensible du système AMM en termes de sécurité, le risque de faille ne peut être négligé.

Le système AMM permet l'envoi de commandes critiques à distance depuis plusieurs niveaux du système (CMS, MDMS, HES). Une erreur humaine peut déclencher l'envoi massif d'une commande critique sur un très grand nombre de compteurs.

Le système AMM peut utiliser un mécanisme de protection de données, tel que « Data Protection » du standard DLMS (de l'anglais « Device Language Message Specification ») qui est un protocole de communication standard utilisé principalement dans le domaine de la gestion de l'énergie. Ce mécanisme de protection permet de sécuriser une commande envoyée au compteur à l'aide d'une clé dédiée à l'authentification des échanges critiques. Cependant, ce mécanisme n'empêche pas un utilisateur malveillant d'envoyer un grand nombre de commandes authentifiées.

La présente invention ajoute un mécanisme de protection par l'implémentation d'un processus de limitation qui limite une quantité de commandes envoyées par période de temps définie. Ce mécanisme de protection peut être implémenté dans le système de gestion et de collecte, plus particulièrement dans un sous-système jouant le rôle de passerelle entre le système de gestion et de collecte et l'ensemble des compteurs. Il peut être mis en œuvre juste avant que la passerelle n'envoie la commande vers le ou les compteurs ciblés.

Ce processus de limitation permet d'ajouter une protection supplémentaire principalement contre deux menaces:
- l'erreur humaine, déclenchée par exemple par un utilisateur du système de gestion et de collecte ayant légitimement le droit de lancer l'exécuter des commandes ;
- la compromission d'un ou plusieurs composants du système de gestion et de collecte susceptibles d'envoyer des commandes à distance aux compteurs par l'intermédiaire de la passerelle.

L'invention ajoute donc une protection contre de telles menaces dans le cas où les barrières de protection de l'état de l'art auraient été outrepassées.

Avantageusement,
- l'étape B comprend une étape de classification de chaque commande en commande critique ou non critique, sur la base d'une liste prédéterminée d'une ou plusieurs commandes critiques ; et
- le processus de limitation est exécuté uniquement pour les commandes critiques.

Dans un mode de réalisation, le processus de limitation comprend les étapes de
- surveiller une quantité de commandes critiques envoyées pendant ladite période de temps définie par rapport à un seuil d'alerte prédéterminé; et
- après atteinte du seuil d'alerte, annuler l'envoi de toute commande critique jusqu'à expiration ladite période de temps définie. Par exemple, différents seuils d'alerte peuvent être appliqués à différents types de commandes critiques.

Dans un mode de réalisation, le procédé comprend, pour toute commande critique dont l'envoi est annulé, une étape de notification d'échec de l'envoi de ladite commande critique vers au moins une entité du système de gestion et de collecte.

Avantageusement, le processus de limitation peut être exécuté de façon itérative sur différentes périodes de temps définies, la quantité de commandes critiques envoyées étant réinitialisée au début de chaque nouvelle période de temps.

Par exemple, le processus de limitation est exécuté de façon itérative :
- à chaque période de temps d'une série continue de périodes de temps consécutives ;
- à chaque période de temps d'une succession de périodes de temps dans laquelle chaque nouvelle période de temps est démarrée, après expiration de la précédente période de temps, à l'envoi d'une nouvelle commande critique; ou
- sur une période de temps glissante.

Dans un mode de réalisation particulier, ladite période de temps et le seuil d'alerte peuvent être prédéterminés par apprentissage automatique sur la base de données d'utilisation de commandes critiques par le système de gestion et de collecte de données de consommation.

Dans un mode de réalisation, le processus de limitation peut comprendre les étapes de:
- détecter si la quantité de commandes à envoyer atteint un seuil d'avertissement, inférieur au seuil d'alerte, durant la période de temps définie ;
- en cas de détection positive, transmettre un message d'avertissement à au moins une entité du système de gestion et de collecte et poursuivre l'envoi de la ou des commandes critiques lors de ladite période de temps.

Dans un mode de réalisation, le processus de limitation peut être exécuté par un module de communication de la passerelle, responsable de la génération et de l'envoi de trames de communication contenant les commandes vers les compteurs concernés à travers une infrastructure de communication.

Avantageusement, la fonction de limitation des commandes, par exemple des commandes critiques, est implémentée dans le module de communication de la passerelle, ayant pour rôle de générer et d'envoyer des trames de communications aux compteurs, ces trames contenant par exemples des commandes. Grâce à cela, le processus de limitation est exécuté au plus proche de l'envoi de la commande vers le ou les compteurs à travers l'infrastructure ou réseau de communication.

Un deuxième aspect de l'invention concerne aussi une passerelle entre un ensemble de compteurs communicants desservis par un réseau de distribution d'énergie et un système de gestion et de collecte de données de consommation, lesdits compteurs étant configurés pour mesurer et gérer une consommation d'énergie, ladite passerelle comprenant des moyens pour mettre en œuvre les étapes du procédé précédemment défini.

Un troisième aspect de l'invention concerne un système de gestion et de collecte de données de consommation comportant la passerelle définie ci-dessus.

Dans un mode de réalisation, le système de gestion et de collecte comprend en outre
- un système de gestion de données agencé pour analyser les données de consommation ;
- un système de gestion de clients agencé pour gérer l'interaction avec des utilisateurs clients,
dans lequel les commandes pour les compteurs sont fournies par l'un au moins des composants comportant le système de gestion de données, le système de gestion de clients et la passerelle.

Un quatrième aspect de l'invention concerne un programme d'ordinateur comprenant des instructions qui conduisent la passerelle définie ci-dessus à exécuter les étapes de la méthode précédemment définie.

Un cinquième aspect de l'invention concerne un support lisible par ordinateur, sur lequel est enregistré le programme d'ordinateur selon la revendication.

### Description des figures

D'autres caractéristiques et avantages de la présente invention apparaîtront plus clairement à la lecture de la description détaillée qui suit d'un mode de réalisation de l'invention donné à titre d'exemple nullement limitatif et illustré par les dessins annexés, dans lesquels :
[fig. 1] représente de façon schématique une infrastructure de collecte et de gestion de données de consommation mesurées par des compteurs communicants, selon un mode particulier de réalisation;

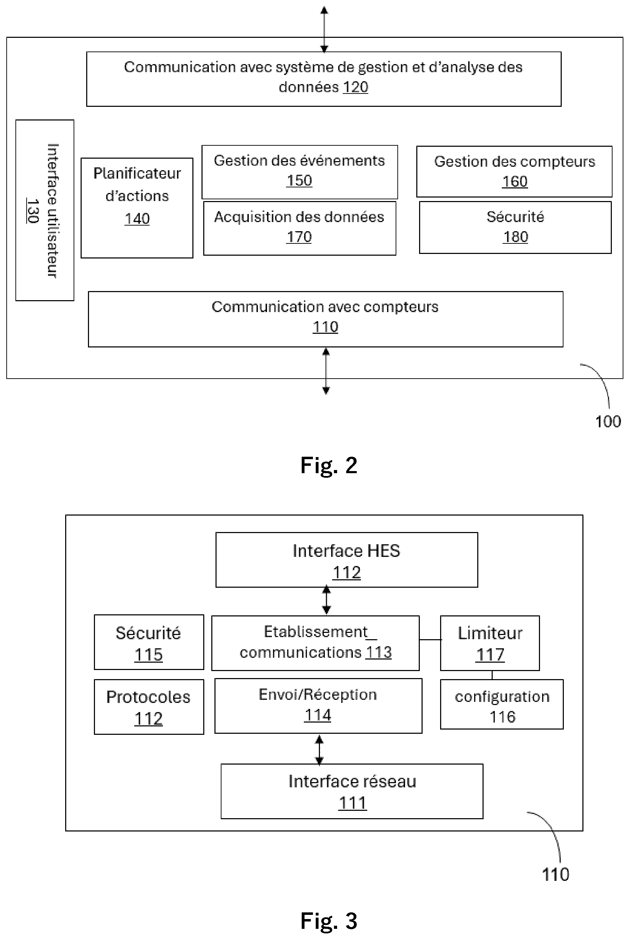

[fig. 2] représente un schéma bloc fonctionnel d'un système de collecte de l'infrastructure de la figure 1, selon une forme particulière de réalisation ;
[fig. 3] représente un schéma bloc fonctionnel d'un composant de communication du système de collecte de la figure 2, selon une forme particulière de réalisation. ;

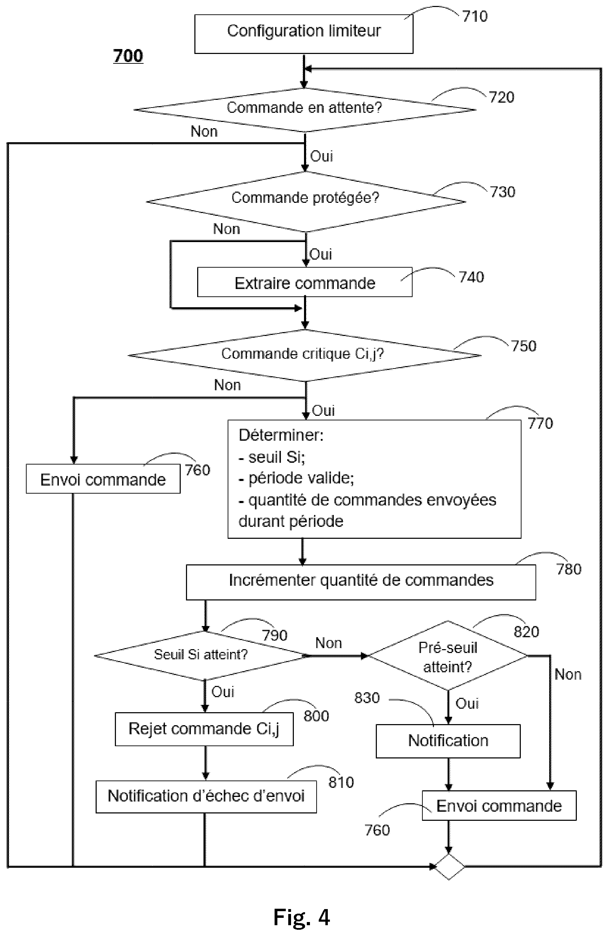

[fig. 4] représente un organigramme d'étapes d'un procédé de commande à distance des compteurs, selon un mode particulier de réalisation.

### Description détaillée de mode(s) de réalisation

La description détaillée qui suit décrit diverses caractéristiques et fonctions des systèmes et procédés divulgués en référence aux figures annexées. Dans les figures, des symboles similaires identifient des composants similaires, sauf indication contraire. Les modes de réalisation illustratifs du système, du dispositif et du procédé décrits ici ne sont pas limitatifs. L'homme du métier comprendra facilement que certains aspects des systèmes, dispositifs et procédés décrits peuvent être agencés et combinés dans une grande variété de configurations différentes, qui sont toutes envisagées ici.

La présente invention concerne un procédé et un système de commande à distance de compteurs communicants desservis par un réseau de distribution d'énergie. Les compteurs communicants sont agencés pour mesurer et gérer une consommation d'énergie en un point de livraison (PDL) et sont en communication avec un système de collecte et de gestion de données de consommation. La présente invention améliore la stabilité du réseau de distribution d'énergie (électricité, gaz, ou eau) par la mise en œuvre d'un processus de limitation du nombre de commandes à distance envoyées par le système de gestion et de collecte aux compteurs par période de temps définie. Ce processus de limitation réduit le risque de déséquilibre entre production et consommation d'énergie et, par conséquent, améliore la stabilité du réseau de distribution d'énergie. Il est exécuté par une passerelle chargée de l'interaction entre le système de gestion et de collecte et les compteurs à travers un réseau de communication. La passerelle est responsable de l'envoi des commandes vers les compteurs à travers le réseau de communication, par exemple en insérant ces commandes dans des trames de communication. Juste avant d'envoyer chaque nouvelle commande, un module de communication avec les compteurs de la passerelle exécute le processus de limitation pour détecter si la quantité de commandes envoyées sur la période de temps définie, a atteint un seuil d'alerte. Si le seuil d'alerte a déjà été atteint sur la période de temps définie, la nouvelle commande n'est pas envoyée. Avantageusement, cette fonction de limitation du nombre de commandes peut être utilisée uniquement pour des commandes critiques, susceptibles d'entraîner un déséquilibre dans le réseau de distribution d'énergie.

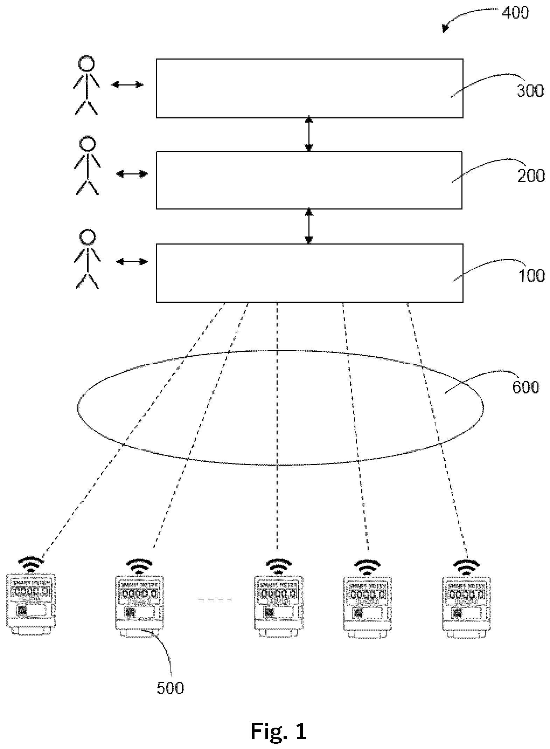

La figure 1 représente de façon schématique un système 400 de gestion et de collecte de données de consommation et un ensemble de compteurs communicants 500, également appelés compteurs intelligents.

Les compteurs communicants 500 sont desservis en énergie (électricité, gaz ou eau) par un réseau de distribution d'énergie (non représenté) et permettent la mesure automatique de données de consommation d'énergie à distance sans intervention humaine sur site. Ils sont connectés au système de gestion et de collecte 400 à travers une infrastructure ou réseau de communication 600, et peuvent interagir avec le système 400.

L'infrastructure de communication 600 peut comprendre un ou plusieurs réseaux tels que des réseaux de télécommunication fixes et mobiles, des réseaux RF mesh, PLC (Power Line Communication), etc. Il s'agit d'une infrastructure externe au système de gestion et de collecte 400.

Le système 400 de gestion et de collecte, par exemple un système AMM (Advanced Metering Management), en français "Gestion Avancée de la Mesure", est un système central ayant pour fonctions de collecter, mesurer, analyser et gérer la consommation d'énergie (électricité, gaz, eau). De façon connue, le système AMM peut comprendre les différents composants suivants :
- un système de gestion de tête ou HES (de l'anglais « Head End System ») 100 ;
- un système de gestion et d'analyse des données ou MDMS (de l'anglais « Meter Data Management System ») 200 ; et
- un système de gestion client ou CMS (de l'anglais « Customer Management System ») 300.

Le système de gestion et d'analyse des données (MDMS) 200 a pour rôle de collecter, stocker, et analyser les données, notamment les données de consommation, provenant des compteurs intelligents 500, facilitant la gestion des données de consommation et leur utilisation pour la facturation, l'analyse de l'utilisation, et la gestion du réseau.

Le système de gestion client (CMS) 300 a pour rôle de gérer les informations client, y compris les comptes, la facturation, les paiements et les services clients. Le CMS utilise les données fournies par le MDMS pour générer des factures et gérer les interactions avec les clients.

Le système de gestion de tête (HES) 100 est une passerelle entre le système de gestion et de collecte 400 et les compteurs 500. Il est notamment chargé de gérer la communication et l'interaction entre les compteurs intelligents 500 et le système 400. Les données collectées par les compteurs 500 sont transmises au système central de gestion des données (MDMS) 200 par l'intermédiaire du système de gestion de tête HES 100. Le système de gestion et de collecte 400 peut également transmettre aux compteurs 500 des commandes (par exemples, commandes de lecture, commandes de configuration, commandes de contrôle par exemple pour activer ou désactiver l'alimentation en énergie, commandes de maintenance, etc.) et autres données (par exemple des données de mise à jour logicielles), provenant du système de gestion et de collecte 400. Ces commandes et/ou données provenant du système de gestion et de collecte 400 sont transmises aux compteurs 500 via le système de gestion de tête (HES) 100. Celui-ci agit comme une passerelle entre les compteurs 500 et le système central de gestion et de collecte des données 400.

Dans un mode de réalisation, les composants du système de gestion de tête (HES) 100 peuvent inclure:
- un module de communication 110 avec les compteurs 500, chargé de la communication avec les compteurs 500 à travers l'infrastructure de communication 600 ;
- un module de communication 120 avec le système de gestion et d'analyse des données avec travers un ou plusieurs liens de communication ;
- un module d'interface utilisateur 130 ;
- un planificateur d'actions 140 ;
- un module de gestion des compteurs 160 ;
- un module d'acquisition de données 170 ;
- un module de sécurité 180.

Le planificateur d'actions 140 a pour rôle d'orchestrer et gérer les différentes tâches et commandes qui doivent être exécutées sur les compteurs intelligents 500. Il peut par exemple planifier et prioriser les opérations sur les compteurs (relevés, mises à jour, etc.), déclencher automatiquement des commandes selon les horaires ou événements prédéfinis, et surveiller l'avancement des tâches.

Le module de gestion des compteurs 160 a pour rôle de gérer l'ensemble des compteurs 500. Il peut par exemple ajouter et enregistrer de nouveaux compteurs 500, et configurer des paramètres de base et des paramètres de communication sur ces nouveaux compteurs 500.

Le module d'acquisition de données 170 est chargé de collecter des données en provenance des compteurs 500. Il peut par exemple effectuer des relevés réguliers ou à la demande des données de consommation d'énergie des compteurs 500, et permettre la collecte de données à la demande pour des besoins spécifiques.

Le module de sécurité 180 est responsable de la gestion de clés cryptographiques utilisées pour sécuriser les communications et les données transmises entre le système de gestion de tête 100 et les compteurs 500.

Le module de communication 110 est chargé de gérer l'interaction entre le système de gestion de tête (HES) 100 et les compteurs 500. Il comprend des composants matériels (hardware) et/ou logiciels (software) pouvant inclure :
- des moyens d'interface réseau 111 permettant de connecter le système de gestion de tête (HES) 100 à l'infrastructure de communication 600 ;
- un adaptateur de protocoles de communication 112 permettant d'utiliser divers protocoles ou combinaisons de protocoles (par exemple, DLMS/TCP/IP, DLMS/UDP/IP, LwM2M/COAP/UDP/IP, LwM2M/COAP/TC^{··}/IP, etc.) pour communiquer avec différents types de compteurs 500 ;
- un bloc d'établissement de connexions 113 pour initialiser et gérer des sessions de communication entre le système de gestion de tête 100 et les compteurs 500 ;
- un bloc d'envoi et/ou réception de données 114 chargé d'envoyer et recevoir des données (données de consommation, mises à jour software, commandes, etc.) vers ou en provenance des compteurs 500 ;
- un bloc de sécurité 115 chargé d'authentifier les compteurs 500 et chiffrer/déchiffrer les données échangées avec les compteurs 500.

Dans un mode de réalisation, le bloc d'envoi et de réception 114 est responsable de :
- générer et d'envoyer des trames de communication vers les compteurs 500 à travers l'infrastructure de communication 600 ;
- recevoir et traiter des trames de communication en provenance des compteurs 500 à travers l'infrastructure de communication 600.

Selon la présente invention, le module de communication 110 comprend en outre un limiteur 117 ayant pour rôle de limiter la quantité de commandes transmises par période de temps définie aux compteurs 500. Le limiteur 117 peut être connecté au bloc d'envoi et de réception 114 ou intégré dans le bloc d'envoi et de réception 114. En outre, il peut être connecté à un bloc de configuration 116 permettant de configurer des paramètres de limitation. Les fonctions et le fonctionnement du limiteur 117 et du bloc de configuration 116 seront décrits plus en détail dans la description qui suit d'un procédé de commande à distance des compteurs 500, selon un mode de réalisation particulier.

On va maintenant décrire un procédé 700 de commande à distance des compteurs 500, selon un mode de réalisation particulier. Le procédé 700 peut être exécuté par le module de communication 110.

Par souci de clarté, seules les étapes du procédé de commande 700 nécessaires à la compréhension de l'invention seront décrites ici. Il est à noter que le procédé de commande 700 peut comprendre d'autres étapes qui ne sont pas explicitement décrites dans ce document mais qui peuvent être intégrées dans la mise en œuvre de l'invention.

Le système de gestion de tête HES 100 peut envoyer des commandes aux compteurs 500. Ces commandes peuvent provenir d'une entité du système de gestion et de collecte 400, par exemple du système central de gestion des données MDMS 200, du système de gestion client CMS 300 ou du système de gestion de tête HES 100 luimême. Elles peuvent comprendre différents types de commandes :
- des commandes de lecture pour récupérer les données de consommation d'énergie sur une période définie ;
- des commandes de configuration pour ajuster des paramètres du compteur (par exemple, configuration de paramètres de mesure, mise à jour de firmware, activation de fonctionnalités spécifiques, etc.) ;
- des commandes de contrôle par exemple pour activer ou désactiver l'alimentation en énergie, régler le puissance maximale disponible pour un consommateur ;
- des commandes de maintenance par exemple pour exécuter des tests pour vérifier l'état de fonctionnement du compteur ;
- etc.

Certaines commandes, telles que les commandes de contrôle pour désactiver l'alimentation en énergie et les commandes de contrôle pour régler la puissance maximale disponible, peuvent avoir un impact important sur la consommation en énergie au niveau du point de livraison. De telles commandes sont considérées comme critiques. Le présent procédé 700 permet de limiter la quantité de commandes critiques envoyées aux compteurs 500 par période de temps définie. En variante, le procédé de commande 700 pourrait s'appliquer à toutes les commandes pour les compteurs 500.

Le procédé comprend une étape 710 de configuration du limiteur 117, mise en œuvre par le bloc de configuration 116. L'étape 710 peut comprendre la configuration de paramètres de limitation de la quantité de commandes transmises aux compteurs 500 par période de temps définie. Ces paramètres de limitation peuvent comprendre tout ou partie de :
- des paramètres spécifiant la période de temps définie pouvant inclure une durée et optionnellement un type de période de temps ;
- une liste de commandes critiques Ci avec i=1, 2, ... contenant une ou plusieurs commandes critiques et, pour chaque commande critique Ci, un seuil d'alerte spécifique Si.

Plusieurs types de période de temps peuvent être utilisés par le limiteur 117 :
- période de temps d'une série continue de périodes de temps consécutives ;
- période de temps glissante, qui est définie par sa durée et un instant courant (fin de la période glissante) et se déplace continuellement en avant à mesure que le temps passe;
- période de temps d'une succession de périodes de temps dans laquelle, après expiration d'une période de temps, une nouvelle période de temps n'est démarrée qu'à l'envoi d'une nouvelle commande critique.

A titre d'exemples illustratifs et non-limitatifs, la liste de commandes critiques peut inclure une commande de contrôle pour désactiver la consommation d'énergie (par exemple, une commande d'ouverture d'un organe de coupure de l'alimentation en énergie) et une commande de contrôle pour réduire la puissance maximale disponible pour un consommateur.

Les différentes commandes critiques Ci de la liste peuvent être associées à différents seuils d'alerte Si sur la période de temps définie. A titre d'exemples purement illustratifs et non limitatifs, les seuils peuvent comprendre un seuil de 1000 commandes critiques d'ouverture d'organe de coupure (i.e., 1000 commandes d'interruption d'alimentation) par heure et un seuil de dix instructions de renouvellement de clé de sécurité par minute. En variante, un seuil d'alerte identique pourrait être configuré pour différentes commandes critiques. Dans une autre variante, une période de temps spécifique pourrait être définie pour chaque commande critique.

Optionnellement, les paramètres de configuration peuvent comprendre un seuil d'avertissement, inférieur au seuil d'alerte. Ce seuil d'avertissement peut être défini comme un pourcentage du seuil d'alerte, par exemple compris entre 70% et 90% du seuil d'alerte. Il permet de détecter que la quantité de commandes critiques Ci par période de temps définie se rapproche du seuil d'alerte Si.

La configuration du limiteur 117 peut être mise en œuvre par le bloc de configuration 116. Elle peut être réalisée par un utilisateur via l'interface utilisateur 130 du système de gestion de tête HES 100. En variante, tout ou partie des paramètres de configuration pourraient être configurées en amont, par exemple par un fabricant du système de gestion de tête HES 100.

La configuration du limiteur 117 est hautement sensible et son accès peut être limité à un profil d'utilisateur dédié et prédéfini dans le système HES 100. L'attribution du profil à un utilisateur peut être gérée conformément à des règles de sécurité du système 400. Les permissions associées à ce profil peuvent être vérifiées par le système HES 100 lors de toute tentative de modification de la configuration du limiteur 117.

Les paramètres de configuration peuvent être stockés en mémoire dans le système de gestion de tête 100. Avantageusement, ils peuvent être stockés dans une mémoire ou base de données sécurisée du système de gestion de tête 100, par exemple une mémoire ou base de données gérée par le module de sécurité 180.

Optionnellement, au démarrage du module de communication 110 et/ou de la passerelle 100, le procédé de commandes à distance comprend une étape de chargement des paramètres de configuration du limiteur 117 depuis la mémoire ou base de données sécurisée du système de gestion de tête HES 100 dans une mémoire du module de communication 110, par exemple une mémoire volatile. L'étape de chargement peut être suivie d'une étape de test consistant à vérifier si la configuration du limiteur 117 s'est bien déroulée, par exemple en vérifiant si des paramètres de limitation ont effectivement été chargés dans le limiteur 116 et optionnellement si ces paramètres contiennent une liste non-vide de commandes critiques.

Si le test est négatif (la configuration du limiteur 116 ne s'est pas déroulée correctement), le procédé 700 peut comprendre une étape de notification d'une alerte. Par exemple, un message d'alerte peut être transmis à une entité du système de gestion et de collecte 400 et/ou à un utilisateur via une interface utilisateur telle que celle 130 du système de gestion de tête HES 100. En variante, si le test est négatif, le procédé 700 pourrait être suivi d'une étape de rejet de toute commande, critique ou non-critique. Cette étape de rejet pourrait être mise en œuvre par le limiteur 117.

Si le test est positif (la configuration du limiteur 116 s'est déroulée correctement), le procédé 700 peut passer à une étape 720 de vérification de commandes en attente de transmission.

On notera que, dans une variante, le test est également positif si la configuration du limiteur 117 comporte une liste vide de commandes critiques. Cela permet le déploiement d'un HES 100 ne contrôlant que des compteurs 500 ne supportant pas de commande considérée critique.

Le système de gestion de tête HES 100 gère, planifie l'envoi des commandes aux compteurs 500, par exemple au moyen du planificateur d'actions 140. Les commandes à transmettre, ou en attente de transmission, sont fournies au module de communication 110 qui est responsable de leur envoi aux compteurs concernés à travers l'infrastructure de communication 600. Ces commandes en attente de transmission peuvent être momentanément stockées dans une mémoire tampon du système de gestion de tête HES 100.

Lors de l'étape 720, le module de communication 110 vérifie si une ou plusieurs commandes pour des compteurs 500 sont en attente de transmission. Dans l'affirmative, le module de communication 110 obtient l'une des commandes en attente de transmission par exemple par lecture dans la mémoire tampon. Il peut par exemple obtenir la commande en attente de plus haute priorité. Dans la négative, le procédé passe à une étape de fin, en attente de commandes à transmettre.

Si la commande en attente de transmission est chiffrée (730 : oui), le procédé 700 peut comprendre une étape de déchiffrement 740 pour déchiffrer cette commande.

Après déchiffrement, ou directement après obtention de la commande en attente si celle-ci n'est pas chiffrée, le procédé 700 comprend une étape 750 de classification de la commande en commande critique ou non-critique. Cette classification peut être réalisée en comparant la commande en attente de transmission Ci,j avec la liste de commandes critiques Ci configurée du limiteur 117.

Si la commande en attente de transmission ne correspond pas à l'une des commandes critiques Ci de la liste de commandes critiques configurée dans le limiteur 117, le procédé 700 passe directement à une étape 760 d'envoi de la commande vers le compteur concerné 500, à travers l'infrastructure de communication 600.

Lors de l'étape d'envoi 760, le module de communication 110 peut établir une session de communication avec le compteur concerné 500, générer une trame de communication contenant la commande à transmettre, et transmettre la trame de communication contenant la commande. Optionnellement, la commande et/ou tout ou partie de la trame de communication peuvent être chiffrées.

Dans un mode de réalisation, le processus de limitation n'est pas appliqué aux commandes non-critiques. Ces commandes non-critiques peuvent être envoyées sans limitation de nombres par période de temps définie.

Dans le mode de réalisation décrit ici, le processus de limitation est mis en œuvre pour chaque type de commande critique de la liste de commandes critiques Ci préconfigurée, sur une succession de périodes de temps définies. Cette succession de périodes peut comprendre une nouvelle période démarrée, après expiration de la précédente période, à l'envoi d'une nouvelle commande critique.

De façon alternative, cette succession de périodes de temps peut être une série continue de périodes consécutives. Dans une autre variante, la période de temps peut être une fenêtre glissante.

Pour chaque type de commande critique de la liste de commandes critiques préconfigurée, le limiteur 117 fait un décompte du nombre de commandes critiques envoyées par le module de communication 110 durant chaque période de temps définie. Autrement dit, chaque période de temps est associée à un décompte de commandes critiques envoyées.

Si la commande en attente de transmission Ci,j correspond à l'une des commandes critiques de la liste de commandes critiques configurée, le procédé 700 passe à l'étape 770 de déterminer, pour cette commande critique :
- un seuil d'alerte associé,
- s'il existe une période de temps valide (non expirée), en cours, associée ; et
- le cas échéant, une quantité de commandes critiques déjà envoyées durant cette période de temps valide.

S'il est déterminé, lors de l'étape 770, qu'il n'y a pas de période valide en cours (la précédente période ayant déjà expiré), une nouvelle période de temps est démarrée et le limiteur 117 réinitialise, redémarre un décompte de commandes critiques pour cette nouvelle période de temps. Avantageusement, le limiteur 117 peut ajouter la présente commande Ci,j en cours d'envoi dans le décompte, lors d'une étape 780.

S'il est déterminé lors de l'étape 770 qu'une période de temps est en cours et n'a pas encore expiré (période valide), le décompte de commandes critiques associé à cette période de temps est incrémenté (par exemple, de +1), lors de l'étape 780 pour tenir compte de la commande critique en cours d'envoi Ci,j.

Dans d'autres modes de réalisation, comme une série continue de périodes de temps successives ou une période de temps glissante, les étapes 770 et 780 seront adaptées en conséquence pour tenir compte des spécificités de ces modes. Par exemple, pour une série continue de périodes de temps successives, le limiteur 117 peut automatiquement déclencher la période suivante et réinitialiser le décompte du nombre de commandes critiques, à l'expiration de la période précédente, sans interruption, lors des étapes 770 et 780. Pour une période de temps glissante, l'étape 770 peut déterminer dynamiquement le début et la fin de la période de temps en fonction de conditions prédéfinies, par exemple en fixant la fin de la période de temps à l'instant courant, ou à un instant prévu d'envoi de la commande en attente.

Lors d'une étape 790, le procédé 700 comprend une étape 790 de vérification du seuil d'alerte Si. Lors de cette étape 790, le limiteur 117 vérifie si le décompte de commandes critiques de type Ci pour la période courante a atteint le seuil d'alerte correspondant Si, ici après incrémentation avec la commande critique en cours d'envoi Ci,j.

En cas de vérification positive à l'étape 790 (i.e., si le décompte de commandes critiques a atteint le seuil d'alerte Si sur la période de temps définie en cours, ici après incrémentation avec la commande Ci,j), le procédé 700 passe à une étape 800 de rejet de la commande critique Ci,j. Cette commande critique Ci,j n'est pas envoyée. Ainsi, dès que le décompte de commandes critiques atteint le seuil d'alerte Si, l'envoi de toute commande critique est rejeté, annulé jusqu'à expiration de la période définie en cours.

Le processus de limitation permet ainsi de surveiller une quantité de commandes critiques Ci envoyées pendant la période de temps définie eu égard au seuil d'alerte Si, et, après atteinte du seuil d'alerte Si, d'annuler l'envoi de toute nouvelle commande critique Ci jusqu'à expiration cette période.

L'étape de rejet 800 peut être suivie d'une étape 810 de notification d'échec de l'envoi de la commande critique Ci,j vers au moins une entité du système de gestion et de collecte 400. Par exemple, un message de notification peut être transmis à l'entité source ayant émis la commande critique Ci,j et/ou à un utilisateur du système de gestion de tête HES 100 via l'interface utilisateur 130.

En cas de vérification négative à l'étape 790 (i.e., si le décompte de commandes critiques n'a pas atteint le seuil d'alerte Si sur la période de temps courante, ici après incrémentation avec la commande Ci,j), le procédé 700 passe à une étape 820 de vérification du seuil d'avertissement, ou pré-seuil avant le seuil d'alerte Si. Lors de cette étape 820, le limiteur 117 vérifie si le décompte de commandes critiques de type Ci pour la période courante a atteint le seuil d'avertissement correspondant, lequel est par exemple égal à un certain pourcentage strictement inférieur à 100% du seuil d'alerte Si.

En cas de vérification positive à l'étape 820 (i.e., si le décompte de commandes critiques a atteint le seuil d'avertissement sur la période de temps courante), le procédé 700 passe à une étape 830 de génération un message d'avertissement signalant que la quantité de commandes critiques Ci envoyées par période de temps définie se rapproche d'un seuil d'alerte. Ce message d'avertissement peut être envoyé par le limiteur 117 à une ou plusieurs entités du système de gestion et de collecte 400, par exemple à l'entité émettrice de la commande critique Ci,j et/ou à un utilisateur du système de gestion de tête HES 100 via l'interface utilisateur 130. Puis le procédé 700 passe à l'étape 760 d'envoi de la commande critiques Ci,j.

En cas de vérification négative à l'étape 820 (i.e., si le décompte de commandes critiques n'a pas atteint le seuil d'avertissement sur la période de temps courante), le procédé 700 passe directement à l'étape 760 d'envoi de la commande critique Ci,j.

L'étape 760 d'envoi de la commande critique Ci,j est analogue à l'étape 760 d'envoi de la commande non-critique précédemment décrite. Plus précisément, le module de communication 110 de la passerelle 100 peut établir une session de communication avec le compteur concerné 500, générer une trame de communication contenant la commande critique à transmettre Ci,j, et transmettre la trame de communication contenant la commande Ci,j.

Après rejet (800) ou envoi (760) de la commande, tout ou partie des étapes 720 à 830 du procédé 700 de commande à distance qui vient d'être décrit sont exécuté de façon itérative. Ce procédé itératif peut être interrompu en cas d'arrêt du module de communication 110 et/ou de la passerelle ou système de gestion de tête (HES)100.

Les étapes du processus de limitation, incluant les étapes 750, 770, 780, 790, 800, 810, 820, 830, peuvent être exécutées par le limiteur 117.

Dans un mode de réalisation, le ou les seuils Si et le ou les paramètres de la période de temps (durée et/ou type de période) utilisés par le processus de limitation peuvent être déterminés au moins partiellement de façon adaptative en fonction d'un usage de commandes critiques par le système 400. Par exemple, le ou les seuils Si associés aux commandes critiques et, pour chaque seuil, la période de temps associée peuvent être déterminés de façon automatique par un module d'apprentissage automatique ou « machine leaming » permettant de configurer les seuils de commande critique Si et les période(s) de temps associées sur la base des données d'utilisation de commandes critiques par le système 400.

### Application industrielle

Un procédé et un système selon la présente invention, ainsi que la fabrication du système, sont susceptibles d'application industrielle.

On comprendra que diverses modifications et/ou améliorations évidentes pour l'homme du métier peuvent être apportées aux différents modes de réalisation de l'invention décrits dans la présente description sans sortir du cadre de l'invention.

## Revendications

1. Procédé de commande (700) à distance d'un ensemble de compteurs communicants (500) desservis par un réseau de distribution d'énergie et en communication avec un système (400) de gestion et de collecte de données de consommation, lesdits compteurs étant configurés pour mesurer et gérer une consommation d'énergie, ledit procédé comprenant les étapes, mises en œuvre par une passerelle entre le système de gestion et de collecte et l'ensemble des compteurs, de :
A- recevoir des commandes pour un ou plusieurs compteurs en provenance du système de gestion et de collecte, lesdites commandes étant destinées à être exécutées par les compteurs concernés ; et
B- envoyer les commandes vers les compteurs concernés;
dans lequel l'étape B comprend la mise en œuvre d'un processus de limitation d'une quantité de commandes envoyées pendant une période de temps définie ;
- détecter si la quantité de commandes à envoyer atteint un seuil d'avertissement, inférieur au seuil d'alerte, durant la période de temps définie ;
- en cas de détection positive, transmettre un message d'avertissement à au moins une entité du système de gestion et de collecte et poursuivre l'envoi de la ou des commandes critiques lors de ladite période de temps.

2. Procédé selon la revendication 1, dans lequel:
- l'étape B comprend une étape de classification de chaque commande en commande critique ou non critique, sur la base d'une liste prédéterminée d'une ou plusieurs commandes critiques ; et
- le processus de limitation est exécuté uniquement pour les commandes critiques.

3. Procédé selon la revendication 2, dans lequel le processus de limitation comprend les étapes de
- surveiller une quantité de commandes critiques envoyées pendant ladite période de temps définie par rapport à un seuil d'alerte prédéterminé; et
- après atteinte du seuil d'alerte, annuler l'envoi de toute commande critique jusqu'à expiration ladite période de temps définie.

4. Procédé selon la revendication 3, dans lequel différents seuils d'alerte sont appliqués à différents types de commandes critiques.

5. Procédé selon la revendication 3 ou 4, comprenant, pour toute commande critique dont l'envoi est annulé, une étape de notification d'échec de l'envoi de ladite commande critique vers au moins une entité du système de gestion et de collecte .

6. Procédé selon la revendication 3 ou 4, dans lequel le processus de limitation est exécuté de façon itérative sur différentes périodes de temps définies, la quantité de commandes critiques envoyées étant réinitialisée au début de chaque nouvelle période de temps.

7. Procédé selon la revendication 6, dans lequel le processus de limitation est exécuté de façon itérative :
- à chaque période de temps d'une série continue de périodes de temps consécutives ;
- à chaque période de temps d'une succession de périodes de temps dans laquelle chaque nouvelle période de temps est démarrée, après expiration de la précédente période de temps, à l'envoi d'une nouvelle commande critique; ou
- sur une période de temps glissante.

8. Procédé selon l'une des revendications 3 à 7, dans lequel ladite période de temps et le seuil d'alerte sont prédéterminés par apprentissage automatique sur la base de données d'utilisation de commandes critiques par le système (400) de gestion et de collecte de données de consommation.

9. Procédé selon l'une des revendications précédentes, dans lequel le processus de limitation est exécuté par un module de communication de la passerelle, responsable de la génération et de l'envoi de trames de communication contenant les commandes vers les compteurs concernés à travers une infrastructure de communication.

10. Passerelle entre un ensemble de compteurs communicants desservis par un réseau de distribution d'énergie et un système de gestion et de collecte de données de consommation, lesdits compteurs étant configurés pour mesurer et gérer une consommation d'énergie, ladite passerelle comprenant des moyens pour mettre en œuvre les étapes du procédé selon l'une quelconque des revendications 1 à 9.

11. Système de gestion et de collecte de données de consommation comportant la passerelle selon la revendication 10.

12. Système de gestion et de collecte selon la revendication 10 comprenant en outre
- un système de gestion de données agencé pour analyser les données de consommation ;
- un système de gestion de clients agencé pour gérer l'interaction avec des utilisateurs clients,
dans lequel les commandes pour les compteurs sont fournies par l'un au moins des composants comportant le système de gestion de données, le système de gestion de clients et la passerelle.

13. Programme d'ordinateur comprenant des instructions qui conduisent la passerelle selon la revendication 10 à exécuter les étapes de la méthode selon l'une des revendications 1 à 9.

14. Support lisible par ordinateur, sur lequel est enregistré le programme d'ordinateur selon la revendication 13.
